# EUROPEAN PATENT SPECIFICATION

(11) **EP 0 510 671 B1**
(45) Date of publication and mention of the grant of the patent: **12.11.1997**
(21) Application number: 92107034.8
(22) Date of filing: 24.04.1992
(51) Int. Cl.: G03F 7/004, G03F 7/022

(54) **Positive resist composition**
Positivarbeitende Resistzusammensetzung
Composition pour photoréserve positive

(30) Priority: 26.04.1991 JP 97263/91; 29.11.1991 JP 316500/91
(43) Date of publication of application: 28.10.1992
(73) Proprietor: SUMITOMO CHEMICAL COMPANY, LIMITED, Chuo-ku Osaka 541 (JP)
(72) Inventor: Uetani, Yasunori, Toyonaka-shi, Osaka-fu (JP); Doi, Yasunori, Takatsuki-shi, Osaka-fu (JP); Hashimoto, Kazuhiko, Ibaraki-shi, Osaka-fu (JP); Osaki, Haruyoshi, Toyonaka.shi, Osaka-fu (JP); Hanawa, Ryotaro, Ibaraki-shi, Osaka-fu (JP)
(74) Representative: VOSSIUS & PARTNER

(56) References cited:
- EP-A- 430 302
- EP-A- 435 502
- EP-A- 0 273 026
- EP-A- 0 346 808
- DE-A- 3 705 342

## Description

The present invention relates to a positive resist composition which comprises a quinone diazide compound, an alkali-soluble resin and a specific solvent system.

A composition containing a compound having a quinone diazide group (a quinone diazide compound) and an alkali-soluble resin finds use as a positive resist in the production of integrated circuits.

Recently, with integrated circuits, miniaturization has proceeded with a rise in the integration level, which results in demands for formation of patterns of submicron order. To form such minute patterns with good reproducibility, the positive resist composition should achieve high resolution, a large γ-value and a good profile and also have high qualities in various process margins such as the exposure margin and the depth of focus.

Since the width of wiring is miniaturized with the increase of the integration level, dry etching is employed in addition to wet etching. For dry etching, the resist is required to have higher resistance to dry etching, namely heat resistance, than ever.

In these years, instead of a conventional mask contact printing method, a reduction projection exposure system attracts attention. One of the serious problems in this new system is low throughput. Namely, in this system, the total exposure time to expose a wafer is very long because of divided and repeated light exposure unlike a batch light exposure system which is employed in the conventional mask contact printing methods.

To solve this problem, an increase in sensitivity of the resist is most important. If the exposure time can be shortened by an increase in the sensitivity, the through-put and, in turn, yield can be improved.

One measure to increase the sensitivity is decrease of the molecular weight of the alkali-soluble resin contained in the resist composition. However, the decrease of the molecular weight encounters some problems, for example, large film thickness loss in an unexposed area (reduction of so-called film thickness retention), worsening of the profile and various process margins, decrease of the γ-value because of the small difference in the dissolving rates in the developing solution between the exposed area and the unexposed area. In addition, the heat resistance of the resist is deteriorated and adhesion of the resist to the substrate is decreased disadvantageously.

Other measures to increase the sensitivity include prolongation of the developing time and increase of the concentration of alkali in the developing liquid. However, they are not preferable since the film thickness retention and, in turn, the resolution are decreased.

To increase the γ-value, it is contemplated to increase an amount of the quinone diazide compound. But, the increase of the amount of the quinone diazide compound may lead to precipitation of fine particles of the quinone diazide compound and the alkali-soluble resin and therefore decrease of the yield of the integrated circuits.

To solve such problems, it may be possible to use a monohydroxycarboxylate ester such as ethyl lactate which has a large dissolving power for the quinone diazide compound and is safer to the human beings than the conventional resist solvent such as ethyleneglycol monoalkyl ether acetate. However, such solvent will increase striations or cause some problem in coating such that an edge of a wafer is not coated.

An object of the present invention is to provide a positive resist composition which has a large γ-value and provides a good profile and a large depth of focus while maintaining other properties required for a resist such as good heat resistance, high resolution, good sensitivity and a good coating property.

According to the present invention, there is provided a positive resist composition comprising, in admixture, an alkali-soluble resin, a quinone diazide compound and a mixed solvent of (B) γ-butyrolactone or cyclohexanone and (A) 2-heptanone.

In the positive resist composition of the present invention, the quinone diazide compound may be any one of conventionally used compounds. For example, the quinone diazide compound is an ester of a below described hydroxyl group-containing compound with a quinone diazide sulfonic acid such as 1,2-benzoquinone diazide-4-sulfonic acid, 1,2-naphthoquinone diazide-4-sulfonic acid or 1,2-naphthoquinone diazide-5-sulfonic acid. Preferably, the quinone diazide compound is an ester of a hydroxyl group-containing compound of the formula: 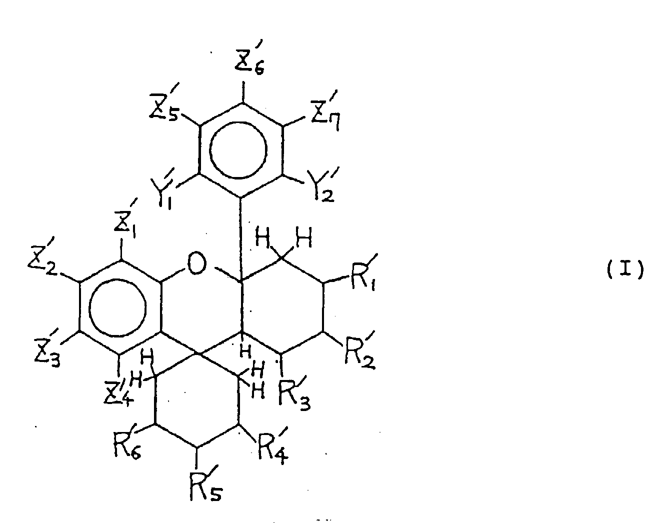 wherein Y₁', Y₂', Z₁', Z₂', Z₃', Z₄', Z₅', Z₆' and Z₇' are the same or different and each represents a hydrogen atom, a hydroxyl group or a C₁-C₄ alkyl group, provided that at least one of Y₁' and Y₂' is a hydroxyl group and at least two of Z₁', Z₂', Z₃', Z₄', Z₅', Z₆' and Z₇' are hydroxyl groups; and R₁', R₂', R₃', R₄', R₅' and R₆' are the same or different and each represents a hydrogen atom, a C₁-C₁₀ alkyl group, a C₂-C₄ alkenyl group, a C₅-C₈ cycloalkyl group or an aryl group, or an oxyflavan compound of the formula: 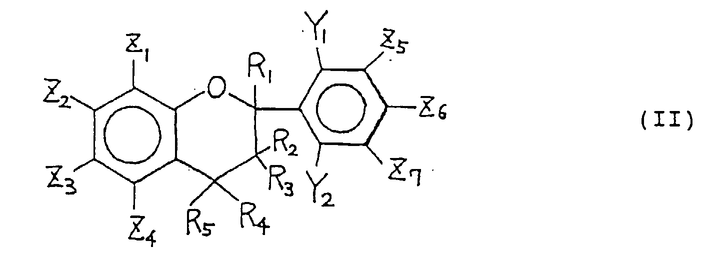 wherein Y₁ and Y₂ are the same or different and each represents a hydrogen atom, a hydroxyl group or a C₁-C₄ alkyl group, provided that at least one of Y₁ and Y₂ is a hydroxyl group; Z₁, Z₂, Z₃, Z₄, Z₅, Z₆ and Z₇ are the same or different and each represents a hydrogen atom, a halogen atom, a hydroxyl group, a C₁-C₄ alkyl group, a C₅-C₈ cycloalkyl group or an aryl group, provided that at least two are hydroxyl groups; and R₁, R₂, R₃, R₄ and R₅ are the same or different and each represents a hydrogen atom, a C₁-C₁₀ alkyl group, a C₂-C₄ alkenyl group, a cyclohexyl group or an aryl group, provided that at least one of R₄ and R₅ is a C₁-C₁₀ alkyl group, a C₂-C₄ alkenyl group, a cyclohexyl group or an aryl group with the above quinone diazide sulfonic acid.

Among them, the quinone diazide sulfonic acid ester of the oxyflavan (II) is preferred.

The quinone diazide compound may be prepared by a per se conventional method. For example, the quinone diazide sulfonic acid and the hydroxyl group-containing compound are condensed in the presence of a weak alkali.

Examples of the hydroxyl group-containing compound are hydroquinone, resorcinol, phloroglucin, 2,4-dihydroxybenzophenone, trihydroxybenzophenones (e.g. 2,3,4-trihydroxybenzophenone, 2,2',3-trihydroxybenzophenone, 2,2',4-trihydroxybenzophenone, 2,2',5-trihydroxybenzophenone, 2,3,3'-trihydroxybenzophenone, 2,3,4'-trihydroxybenzophenone, 2,3',4-trihydroxybenzophenone, 2,3',5-trihydroxybenzophenone, 2,4,4'-trihydroxybenzophenone, 2,4',5-trihydroxybenzophenone, 2',3,4-trihydroxybenzophenone, 3,3',4-trihydroxybenzophenone, 3,4,4'-trihydroxybenzophenone, etc.), tetrahydroxybenzophenones (e.g. 2,3,3',4'-tetrahydroxybenzophenone, 2,3,4,4'-tetrahydroxybenzophenone, 2,2',4,4'-tetrahydroxybenzophenone, 2,2',3,4-tetrahydroxybenzophenone, 2,2',3,4'-tetrahydroxybenzophenone, 2,2',5,5'-tetrahydroxybenzophenone, 2,3',4',5-tetrahydroxybenzophenone, 2,3',5,5'-tetrahydroxybenzophenone, etc.), pentahydroxybenzophenones (e.g. 2,2',3,4,4'-pentahydroxybenzophenone, 2,2',3,4,5'-pentahydroxybenzophenone, 2,2',3,3',4-pentahydroxybenzophenone, 2,3,3',4,5'-pentahydroxybenzophenone, etc.), hexahydroxybenzophenones (e.g. 2,3,3',4,4',5-hexahydroxybenzophenone, 2,2',3,3',4,5'-hexahydroxybenzophenone, etc.), alkyl gallates, the compound of the formula (I), a compound which is disclosed in Japanese Patent Kokai Publication No. 269351/1990 corresponding U.S. Patent Application Ser. No. 07/347,065 and EP-A-0 341 608, and represented by the formula: 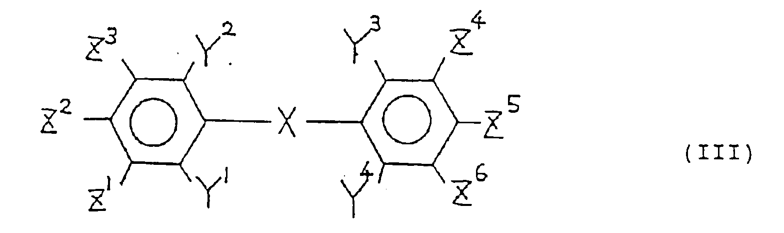 wherein Y¹, Y², Y³ and Y⁴ are the same or different and each a hydrogen atom, a halogen atom, an alkyl group or a hydroxyl group provided that at least one of them is a hydroxyl group; Z¹, Z², Z³, Z⁴, Z⁵ and Z⁶ are the same or different and each a hydrogen atom, a halogen atom, an alkyl group, an aryl group or a hydroxyl group provided that at least one of them is a hydroxyl group; and X is a group of the formula: -C(R¹)(R²)- in which R¹ and R² are the same or different and each a hydrogen atom, an alkyl group, an alkenyl group, a cycloalkyl group, an alkoxyl group or an aryl group provided that when at least one of them is a hydrogen atom, an alkyl or aryl group is present at an ortho-position to a hydroxyl group which is present at an ortho-position to the group X.

As the alkali-soluble resin, polyvinylphenol, a novolak resin and the like are exemplified.

The novolak resin is prepared by a condensation reaction of a phenol with an aldehyde. Specific examples of the phenol used as one of the raw materials for the novolak resin include phenol, o-, m- or p-cresol, 2,5-, 3,5- or 3,4-xylenol, xylenol, 2,3,5-trimethylphenol, 4-, 2- or 3-tert.-butylphenol, 3-, 2- or 4-ethylphenol, 3-methyl-6-tert.-butylphenol, 4-methyl-2-tert.-butylphenol, 2-naphthol, 1,3-, 1,7- or 1,5-dihydroxynaphthalene, and the like. These phenols may be used alone or in combination.

Examples of the aldehyde are aliphatic aldehydes (e.g. formaldehyde, acetaldehyde, etc.), aromatic aldehydes (e.g. benzaldehyde, o-, m- or p-hydroxybenzaldehyde, o- or p-methylbenzaldehyde, etc.) and the like.

A weight ratio of the quinone diazide compound to the alkali-soluble resin is preferably from 1:1 to 1:7.

A weight ratio of the organic solvent (A) and the organic solvent (B) is preferably from 98:2 to 30:70, more preferably from 95:5 to 40:60.

When the organic solvent (B) content is too low, the γ-value is decreased and the profile is worsened. When the organic solvent (B) content is too high, the coating property is deteriorated.

The solvent mixture to be used in the present invention is used in an amount that a coating film is uniformly formed on the wafer and no pin hole or irregular coating is found. Preferably, the solvent system is used in an amount such that the total amount of the quinone diazide compound and the alkali-soluble resin is from 3 to 50 % by weight based on the total weight of the resist composition.

The positive resist composition is prepared by mixing and dissolving the quinone diazide compound and the alkali-soluble resin in the solvent system of the present invention.

The positive resist composition of the present invention may contain other conventionally used additives such as sensitizers, other additional resins, surfactants, stabilizers or dyes which increase the visibility of the formed figure and conventional additives.

The positive resist composition of the present invention has a large γ-value and is excellent in profile and depth of focus.

The present invention is illustrated in more detail by the following Examples. In these Examples, the "parts" are by weight.

### Examples 1 to 16 and Comparative Examples 1 to 5

A mixture of a novolak resin and a quinone diazide compound in amounts shown in the Table was dissolved in a solvent (45 parts). The resulting solution was filtered through a TEFLON™ filter of 0.2 µm pore size. The resist solution was coated on a silicon wafer, which had been rinsed in the usual way, by means of a spinner so as to form a resist film of 1.3 µm thickness. Subsequently, the silicon wafer was baked for 60 seconds on a hot plate kept at 100°C, and exposed to light having a wavelength of 365 nm (i line) while varying the exposure time stepwise by means of a reduction projection exposing apparatus (LD-5010i with NA of 0.40 manufactured by Hitachi). Thereafter, the silicon wafer was baked (post exposure baking) on a hot plate kept at 110°C for 60 seconds and developed for one minute in a developing solution (SOPD manufactured by Sumitomo Chemical Co., Ltd.) to obtain a positive pattern.

The resolution is evaluated by measuring the minimum size of the line-and-space pattern at which the pattern is separated without film thickness decrease at an exposure amount at which a line/space ratio (L/S) is 1:1 in the line-and-space pattern of 0.8 µm, with a scanning electron microscope.

The profile in the Table is the cross sectional shape of the 0.8 µm line-and-space pattern at the above exposure amount.

The γ-value is expressed in terms of tanθ, the angle θ of which is obtained by plotting a standardized film thickness (= the retained film thickness/the original film thickness) against the logarithm of the exposure amount and calculating the inclination of the plotted line. The sensitivity (Eth) is an exposure amount at which the standardized film thickness is zero.

Heat resistance of the resist is expressed in terms of the maximum temperature at which a 3 µm line-and-space pattern is not deformed when the wafer having the pattern is heated on a hot plate for 3 minutes. The deformation of the pattern is observed with a scanning electron microscope.

The depth of focus is defined by measuring the width of focus values with which a 0.6 µm line-and-space pattern is separated at an exposure amount at which the line/space ratio is 1:1 without causing film thickness decrease and forming an extreme reverse tapered profile.

The results are shown in the Table below.

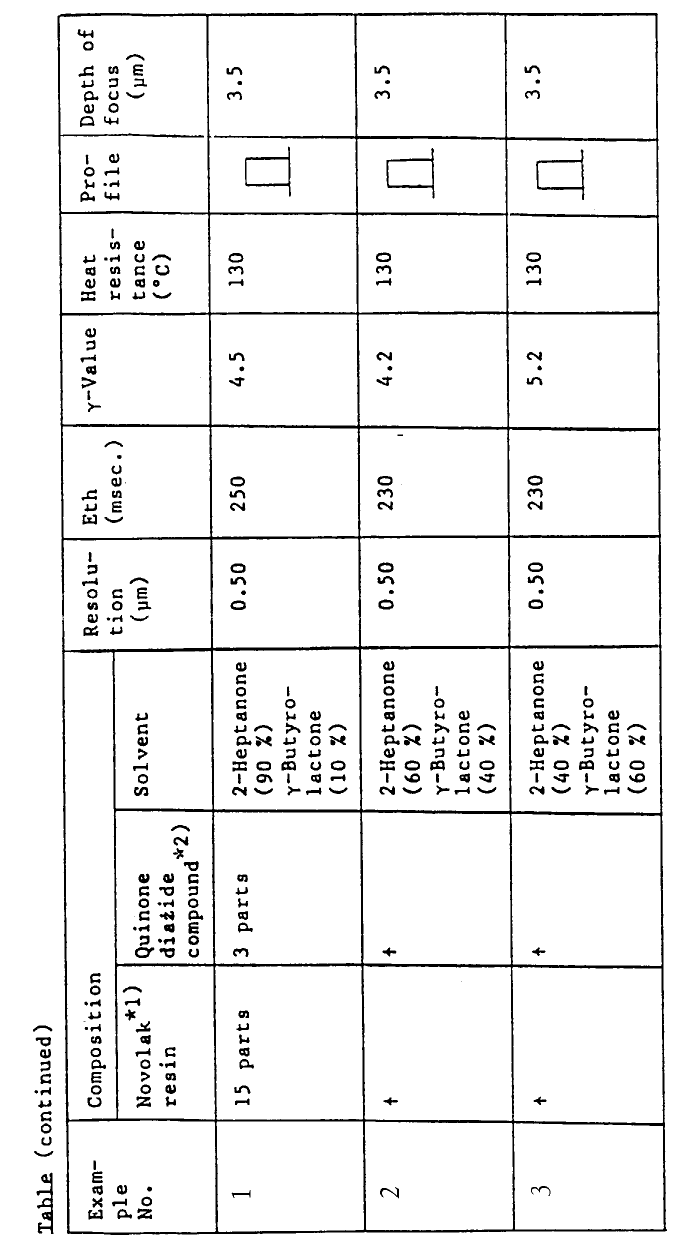

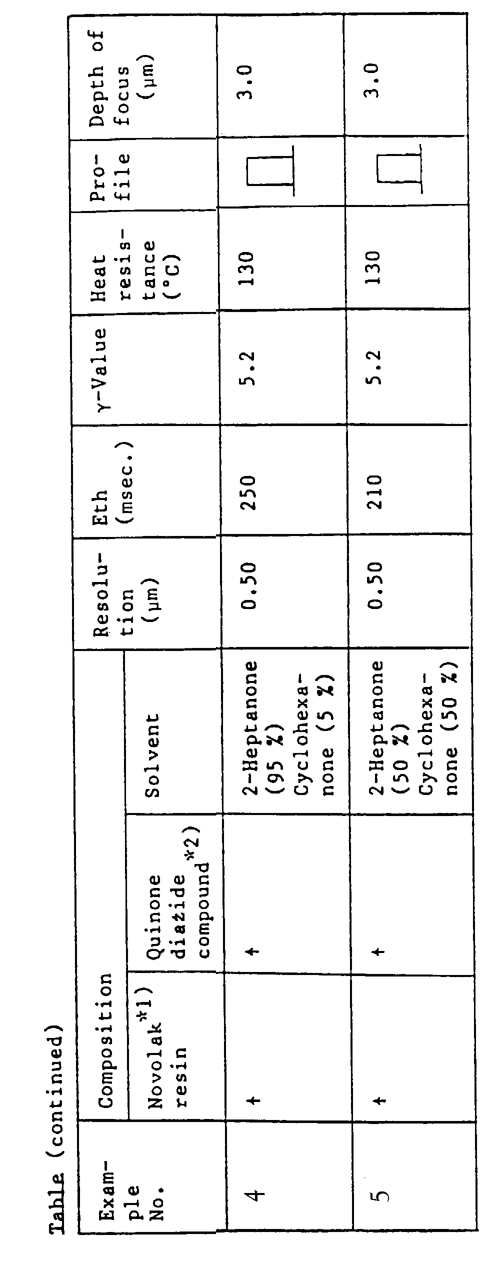

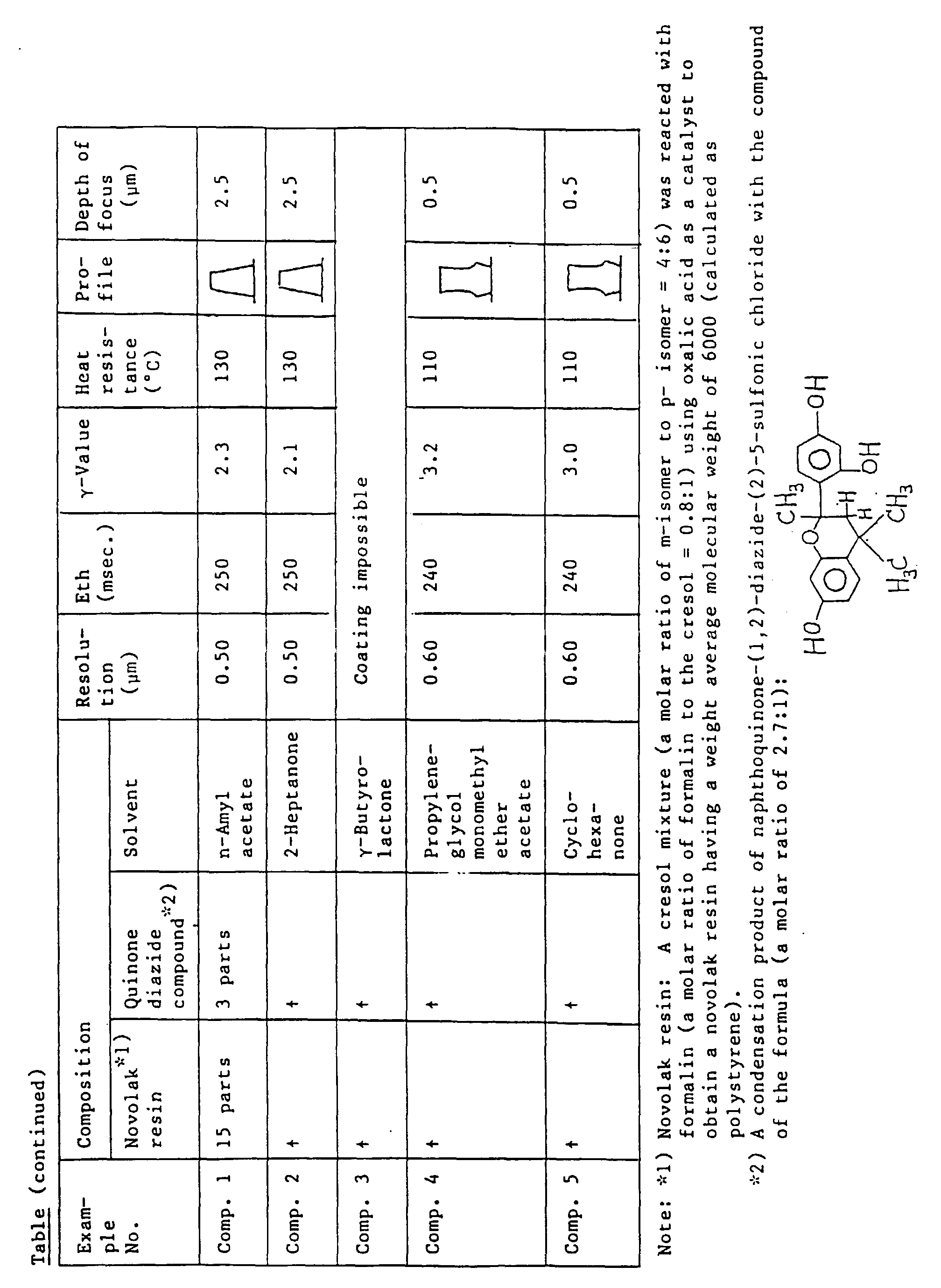

## Claims

1. A positive resist composition comprising, in admixture, an alkali-soluble resin, a quinone diazide compound and a mixed solvent of (B) γ-butyrolactone or cyclohexanone and (A) 2-heptanone.

2. The positive resist composition according to claim 1, wherein the weight ratio of said organic solvent (A) to said organic solvent (B) is from 98:2 to 30:70.

3. The positive resist composition according to claim 1, wherein said quinone diazide compound is an ester of an oxyflavan compound of the formula: 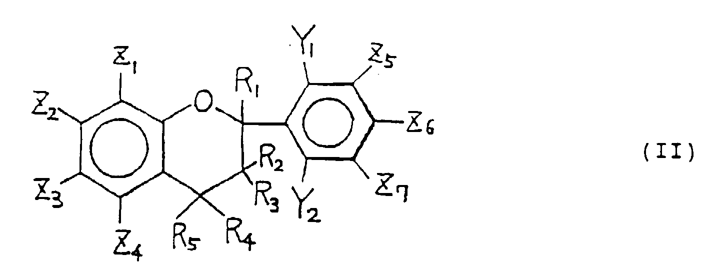 wherein Y₁ and Y₂ are the same or different and each represents a hydrogen atom, a hydroxyl group or a C₁-C₄ alkyl group, provided that at least one of Y₁ and Y₂ is a hydroxyl group; Z₁, Z₂, Z₃, Z₄, Z₅, Z₆ and Z₇ are the same or different and each represents a hydrogen atom, a halogen atom, a hydroxyl group, a C₁-C₄ alkyl group, a C₅-C₈ cycloalkyl group or an aryl group, provided that at least two of Z₁, Z₂, Z₃, Z₄, Z₅, Z₆ and Z₇ are hydroxyl groups; and R₁, R₂, R₃, R₄ and R₅ are the same or different and each represents a hydrogen atom, a C₁-C₁₀ alkyl group, a C₂-C₄ alkenyl group, a cyclohexyl group or an aryl group provided that at least one of R₄ and R₅ is a C₁-C₁₀ alkyl group, a C₂-C₄ alkenyl group, a cyclohexyl group or an aryl group
with a quinone diazide sulfonic acid.

4. The positive resist composition according to claim 1, wherein said alkali-soluble resin is a novolak resin.

## Patentansprüche

1. Positiv arbeitende Resistzusammensetzung, umfassend als Gemisch ein alkalilösliches Harz, eine Chinondiazidverbindung und ein Lösungsmittelgemisch aus (B) γ-Butyrolacton oder Cyclohexanon und (A) 2-Heptanon.

2. Positiv arbeitende Resistzusammensetzung nach Anspruch 1, in der das Gewichtsverhältnis des organischen Lösungsmittels (A) zum organischen Lösungsmittel (B) 98:2 bis 30:70 beträgt.

3. Positiv arbeitende Resistzusammensetzung nach Anspruch 1, in der die Chinondiazidverbindung ein Ester einer Oxyflavanverbindung der Formel: 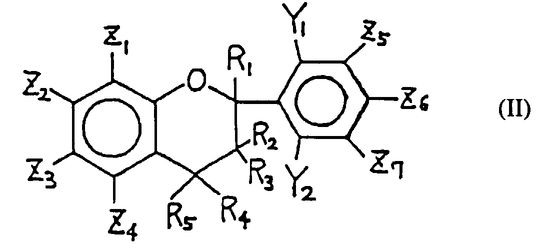 in der Y₁ und Y₂ gleich oder verschieden sind und jeweils ein Wasserstoffatom, eine Hydroxylgruppe oder einen C₁-C₄-Alkylrest bedeuten, mit der Maßgabe, daß wenigstens einer der Reste Y₁ und Y₂ eine Hydroxylgruppe ist; Z₁, Z₂, Z₃, Z₄, Z₅, Z₆ und Z₇ gleich oder verschieden sind und jeweils ein Wasserstoffatom, ein Halogenatom, eine Hydroxylgruppe, einen C₁-C₄-Alkylrest, einen C₅-C₈-Cycloalkylrest oder einen Arylrest bedeuten, mit der Maßgabe, daß wenigstens zwei der Reste Z₁, Z₂, Z₃, Z₄, Z₅, Z₆ und Z₇ Hydroxylgruppen sind; und R₁, R₂, R₃, R₄ und R₅ gleich oder verschieden sind und jeweils ein Wasserstoffatom, einen C₁-C₁₀-Alkylrest, einen C₂-C₄-Alkenylrest, eine Cyclohexylgruppe oder einen Arylrest bedeuten, mit der Maßgabe, daß wenigstens einer der Reste R₄ und R₅ ein C₁-C₁₀-Alkylrest, ein C₂-C₄-Alkenylrest, eine Cyclohexylgruppe oder ein Arylrest ist,
mit einer Chinondiazidsulfonsäure ist.

4. Positiv arbeitende Resistzusammensetzung nach Anspruch 1, in der das alkalilösliche Harz ein Novolakharz ist.

## Revendications

1. Composition de réserve positive comprenant, en mélange, une résine soluble dans les alcalis, un composé quinonediazide et un mélange solvant de (B) γ-butyrolactone ou cyclohexanone et de (A) 2-heptanone.

2. Composition de réserve positive selon la revendication 1, dans laquelle le rapport en poids dudit solvant organique (A) audit solvant organique (B) est situé entre 98/2 et 30/70.

3. Composition de réserve positive selon la revendication 1, dans laquelle ledit composé quinonediazide est un ester d'un composé oxyflavane de formule : 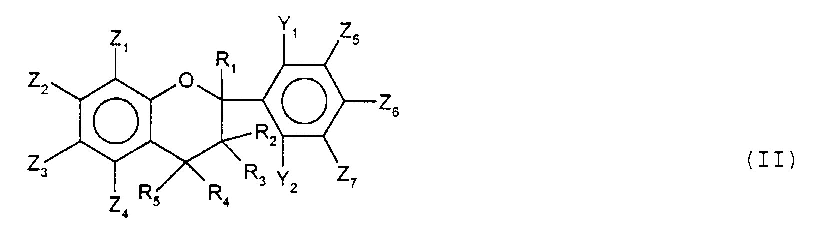 dans laquelle Y₁ et Y₂, qui peuvent être identiques ou différents, représentent chacun un atome d'hydrogène, un groupe hydroxyle ou un groupe alkyle en C₁ à C₄, du moment qu'au moins l'un de Y₁ et Y₂ est un groupe hydroxyle ; Z₁, Z₂, Z₃, Z₄, Z₅, Z₆ et Z₇, qui peuvent être identiques ou différents, représentent chacun un atome d'hydrogène, un atome d'halogène, un groupe hydroxyle, un groupe alkyle en C₁ à C₄, un groupe cycloalkyle en C₅ à C₈ ou un groupe aryle, du moment qu'au moins deux des groupes Z₁, Z₂, Z₃, Z₄, Z₅, Z₆ et Z₇ sont des groupes hydroxyle ; et R₁, R₂, R₃, R₄ et R₅, qui peuvent être identiques ou différents, représentent chacun un atome d'hydrogène, un groupe alkyle en C₁ à C₁₀, un groupe alcényle en C₂ à C₄, un groupe cyclohexyle ou un groupe aryle, du moment qu'au moins l'un de R₄ et R₅ est un groupe alkyle en C₁ à C₁₀, un groupe alcényle en C₂ à C₄, un groupe cyclohexyle ou un groupe aryle,
avec un acide quinonediazidesulfonique.

4. Composition de réserve positive selon la revendication 1, dans laquelle ladite résine soluble dans les alcalis est une résine novolaque.
